# EUROPÄISCHE PATENTSCHRIFT

(11) **EP 3 024 592 B1**
(45) Veröffentlichungstag und Bekanntmachung des Hinweises auf die Patenterteilung: **05.09.2018**
(21) Anmeldenummer: 14796667.5
(22) Anmeldetag: 22.07.2014
(51) Int. Cl.: B05C 5/02, G10K 15/00, B05B 13/02, B21B 45/02, B08B 5/02, B23K 26/00, H01J 37/32, B05C 19/04

(54) **VORRICHTUNG ZUR OBERFLÄCHENBEHANDLUNG ODER -BEARBEITUNG**
DEVICE FOR THE TREATMENT OR PROCESSING OF SURFACES
DISPOSITIF DE TRAITEMENT OU D'USINAGE DE SURFACES

(30) Priorität: 22.07.2013 DE 102013012173
(43) Veröffentlichungstag der Anmeldung: 01.06.2016
(73) Patentinhaber: ZS-Handling GmbH, 93055 Regensburg (DE)
(72) Erfinder: SCHILP, Michael, 93055 Regensburg (DE); ZIMMERMANN, Josef, 93055 Regensburg (DE); ZITZMANN, Adolf, 92552 Teunz (DE)
(74) Vertreter: Staudte, Ralph
(86) Internationale Anmeldenummer: PCT/DE2014/000374
(87) Internationale Veröffentlichungsnummer: WO 2015/010680

(56) Entgegenhaltungen:
- DE-A1-102007 052 530
- DE-A1-102010 027 031
- US-A- 4 485 387
- US-A- 4 520 049
- US-A1- 2011 311 320

## Beschreibung

Die Erfindung betrifft eine Vorrichtung zur Behandlung von oder zur Einwirkung auf Werkstückoberflächen mittels eines Aktuators, wie z. B. eines Lasers zum Schneiden oder Gravieren, einer Düse zum Aufbringen von Ölen, Lacken, Klebstoffen, Farben, Ätzmitteln, Trennmitteln, usw. Die Erfindung betrifft insbesondere eine Vorrichtung, die dazu geeignet ist, auf Werkstücke mit relativ großen Oberflächen - bezogen auf die Abmessungen des Aktuators - einzuwirken, wie z. B. auf Bandmaterialien.

Aus dem Stand der Technik sind Systeme bekannt, die es ermöglichen, den Arbeitsbereich eines Aktuators in der x-, y- und z-Richtung bezüglich der Werkstückoberfläche genau zu justieren. Für das Justieren eines Aktuators in der x- und y-Richtung werden z. B. Traversen verwendet, die mit Längenmessgeräten gekoppelt sind. Solche Systeme werden nachfolgend als Linearantriebe bezeichnet.

In Abhängigkeit vom Prozess der Oberflächenbehandlung oder von der Einwirkung einer Behandlung auf die Oberfläche sind unterschiedlich hohe Genauigkeiten bei der Positionierung des Aktuators erforderlich.

Für das Positionieren eines Aktuators bezüglich einer Werkstückoberfläche sind verschiedene Konstruktionen bekannt. Aus dem Stand der Technik ist insbesondere bekannt, mittels Sensoren, welche Längen und Abstände messen, den Aktuator mit der technologisch geforderten Genauigkeit zu positionieren und über die Werkstückoberfläche zu führen, um diese zu bearbeiten. Dabei müssen bestimmte Bedingungen eingehalten werden, wie z. B. die Positioniergenauigkeit, die Regelbarkeit, das Gewicht des Aktuators, das Bauvolumen oder auch möglichst geringe Fertigungskosten der für das Positionieren des Aktuators verwendeten Konstruktion.

Grundsätzlich ist gefordert, dass das Positioniersystem den vom Aktuator durchzuführenden Bearbeitungsprozess nicht beeinflusst, d. h. nicht stört. Wenn der Abstand eines Aktuators zur Werkstückoberfläche überwacht werden soll, kann das mit einem taktil arbeitenden Messsystem erfolgen, welches an seinem vorderen Ende ein Rad aufweist, das auf der Werkstückoberfläche abrollt. Eine mechanische Abtastung ist jedoch nur bei einer relativ festen Oberfläche möglich. Bei berührungsempfindlichen Oberflächen werden Abstandssensoren verwendet, welche die Werkstückoberfläche berührungslos abtasten, wie z. B. kapazitive und induktive Abstandssensoren oder auch Staudruckdüsen, die pneumatisch arbeiten. Diese Sensoren können jedoch den Bearbeitungsprozess stören oder vom Bearbeitungsprozess gestört werden. So kann das aus der Staudruckdüse austretende Gas, meist Druckluft, in der Nähe einer Farbsprühdüse Verwirbelungen erzeugen. Solche Störungen können auch bei dem Aufbringen von Ätzmitteln, Lacken oder dünnflüssigen Klebstoffen auftreten. So könnte auch beim Schutzgasschweißen der Luftstrom einer Staudruckdüse das Schutzgas verwirbeln.

Weiterhin ist anzumerken, dass die durch den Aktuator freigesetzten festen, flüssigen oder gasförmigen Stoffe oder auch die bei der Behandlung der Werkstückoberfläche entstehenden Stoffe die Messgenauigkeit der Abstandssensoren beeinflussen können. Wenn Prozessflüssigkeiten in den Bereich von z. B. Messelektroden gelangen, werden die Abstandsmesssignale verfälscht.

Diese Probleme sind dann behebbar, wenn das Messsystem zur Messung des Abstandes zwischen dem Aktuator und der Werkstückoberfläche vom Aktuator räumlich getrennt ist. Ein vom Aktuator weit entfernt angeordnetes Messsystem erzeugt jedoch einen größeren Messfehler als ein unmittelbar am Aktuator angeordnetes Messsystem. Außerdem ist ein erhöhter gerätetechnischer Aufwand erforderlich, um den Messfehler zu verringern.

In den Dokumenten DE 10059232 C2, DE 19938328 C2, DE 102010027031 A1 und DE 102007047298 B3 sind Vorrichtungen und Verfahren beschrieben, die mittels einer Sensoranordnung eine Arbeitseinheit in einem vorbestimmten Abstand über einer Werkstückoberfläche positionieren.

In dem Dokument US 4520049 A sind darüber hinaus eine Vorrichtung und ein Verfahren zum Beschichten eines zwischen einer Basismaterialtransportwalze und einem Düsenkopf hindurchgeführten Basismaterials mit einem viskosen Material beschrieben. Der Düsenkopf zum Ausstoßen des viskosen Materials ist an einer beweglichen Platte befestigt, die mithilfe von mechanischen Federn oberhalb des Basismaterials verschiebbar aufgehängt ist. Eine Vorspannungswirkung der Federn kann mittels Justiermuttern verändert werden, wodurch vor der Beschichtung ein von dem Düsenkopf in Richtung der Basismaterialtransportwalze ausgeübter Beschichtungsdruck eingestellt werden kann. Während der Beschichtung wirkt ein Ausstoßdruck des ausgestoßenen viskosen Materials dem Beschichtungsdruck entgegen, sodass der Düsenkopf über dem Basismaterial schwebt.

Die Aufgabe der Erfindung besteht in der Bereitstellung einer Vorrichtung zur Oberflächenbehandlung oder -bearbeitung, welche mit einer Konstruktion für das Positionieren des Aktuators ausgerüstet ist, um den Aktuator in einem vorbestimmten Abstand bezüglich einer zu behandelnden oder zu bearbeitenden Werkstückoberfläche präzise zu positionieren. Insbesondere soll diese Konstruktion den Prozess der Oberflächenbehandlung oder Oberflächenbearbeitung nicht stören.

Diese Aufgabe wird mit einer Vorrichtung zur Oberflächenbehandlung oder -bearbeitung nach Anspruch 1 mit nachfolgenden Merkmalen gelöst:
- einem Aktuator zum Einwirken auf eine Werkstückoberfläche oder zum Bearbeiten einer Werkstückoberfläche,
- wenigstens einer Sonotrode, die eine Schallabstrahlfläche aufweist und mechanisch starr mit dem Aktuator verbunden ist, um eine Arbeitseinheit zu bilden, und
- einer mit der Arbeitseinheit gekoppelten beweglichen Positioniervorrichtung zum Positionieren der Arbeitseinheit in Gegenüberlage zur Werkstückoberfläche, wobei
- die Positioniervorrichtung ein Drängmittel aufweist, welches die Arbeitseinheit mit einer vorbestimmten Kraft in Richtung Werkstückoberfläche drängt. Unter Drängmittel sind alle technischen Mittel zu verstehen, die geeignet sind, die Arbeitseinheit mittels einer vorbestimmten Drängkraft gegen die Werkstückoberfläche zu drängen.

Die Drängkraft kann durch eine mechanische Feder, durch einen gesteuerten mechanischen Antrieb, einen hydraulischen oder einen pneumatischen Antrieb, aber auch durch magnetische Anziehung oder Abstoßung sowie durch eine von einer Masse bewirkte Gravitationskraft oder durch ein Vakuum erzeugt werden.

Weiterhin ist die Schallabstrahlfläche der Sonotrode ausgebildet, um solche Ultraschall-Schwingungen auszuführen, dass unter Anwesenheit eines gasförmigen Mediums zwischen der Werkstückoberfläche und der Schallabstrahlfläche ein Ultraschall-Levitationskraftfeld wirkt, welches eine gegen die Drängkraft gerichtete Gegenkraft generiert, wodurch die Arbeitseinheit beabstandet zur Werkstückoberfläche gehalten wird.

Der Aktuator ist ausgebildet, um flüssige, pastöse, pulverförmige oder aerosolartige Medien auf die Werkstückoberfläche aufzubringen oder um elektrische, magnetische oder elektromagnetische Felder an der Werkstückoberfläche zu erzeugen und diese zu verändern oder um ein Ultraschallfeld zum Einwirken auf die Werkstückoberfläche zu erzeugen oder um durch Aufbringen mechanischer Mittel auf die Werkstückoberfläche Material von dieser abzutragen.

Der Vorteil dieser Vorrichtung besteht darin, dass das Ultraschall-Levitationskraftfeld weder auf die bei der Oberflächenbehandlung oder -bearbeitung eingesetzten, noch auf die bei der Oberflächenbehandlung oder -bearbeitung freigesetzten festen, flüssigen oder gasförmigen Stoffe einen nennenswerten Einfluss hat. Dadurch wird der Prozess der Oberflächenbehandlung oder Oberflächenbearbeitung nicht gestört.

Nach Anspruch 2 sind an der Arbeitseinheit Prozessüberwachungssensoren zur Prozessüberwachung oder zur Prozesssteuerung angeordnet. Dadurch ist es möglich, die bei der Oberflächenbehandlung oder Oberflächenbearbeitung eventuell entstandenen Fehler schnell zu erkennen und zu korrigieren. Das ist dann besonders vorteilhaft, wenn sehr lange bandförmige Materialien wie z. B. Stahlblech oder Kunststofffolie bearbeitet oder behandelt werden sollen, die anschließend aufgewickelt werden. Bezogen auf die Bewegung des bandförmigen Materials sind die Prozessüberwachungssensoren hinter der Arbeitseinheit angeordnet und mit dieser starr verbunden. Dadurch sind diese Prozessüberwachungssensoren ebenso exakt positioniert wie die Arbeitseinheit selbst, sodass Messfehler, die durch Abstandsschwankungen zur Werkstück- oder Materialoberfläche eintreten könnten, vermieden werden.

Nach Anspruch 3 sind die Prozessüberwachungssensoren optische Sensoren, die Bildsignale von der behandelten oder bearbeiteten Werkstückoberfläche bereitstellen. Diese Bildsignale werden an Bilderkennungssysteme angeschlossen, die z. B. bereits geringfügige Farbabweichungen einer Lackierung anzeigen können.

Nach Anspruch 4 sind die Prozessüberwachungssensoren kapazitive Sensoren, welche die durch die Oberflächenbehandlung oder -bearbeitung verursachten Kapazitätsänderungen der gerade behandelten oder bearbeiteten Werkstückoberfläche als elektrische Messsignale bereitstellen.

Nach Anspruch 5 sind die Prozessüberwachungssensoren induktive Sensoren, welche die durch die Oberflächenbehandlung oder -bearbeitung verursachten Induktivitätsänderungen der gerade behandelten oder bearbeiteten Werkstückoberfläche als elektrische Messsignale bereitstellen.

Nach Anspruch 6 sind die Prozessüberwachungssensoren bezogen auf eine Arbeitsbewegung vor und hinter der Arbeitseinheit vorgesehen. Diese Anordnung ermöglicht einen Vergleich der unbearbeiteten oder unbehandelten Werkstückoberfläche mit der bearbeiteten oder behandelten Werkstückoberfläche.

Nach Anspruch 7 sind die Prozessüberwachungssensoren bezogen auf eine Arbeitsbewegung des Werkstücks oder des Materials hinter der Arbeitseinheit angeordnet. Hinter diesen Prozessüberwachungssensoren ist eine zweite Arbeitseinheit angeordnet. Mit dieser Anordnung sind z. B. Nachkorrekturen möglich, wenn festgestellt wird, dass das Ergebnis der Oberflächenbehandlung oder -bearbeitung mittels der ersten Arbeitseinheit zu korrigieren ist.

Nach Anspruch 8 ist eine Abstandssteuerung zur Steuerung des Abstandes zwischen der Werkstückoberfläche und der Arbeitseinheit vorgesehen. Das wird durch eine Erhöhung oder eine Absenkung der Schallenergie erreicht.
- Fig. 1: zeigt schematisch eine Vorrichtung zum Aufbringen von Öl.
- Fig. 2: zeigt schematisch eine Vorrichtung zum Ätzen der Oberfläche.
- Fig. 3: zeigt schematisch eine Vorrichtung zum Aufbringen von pulverförmigen Feststoffen.
- Fig. 4: zeigt schematisch eine Vorrichtung zum Aushärten von Lacken.
- Fig. 5: zeigt schematisch eine Vorrichtung zum Aufbringen von Aerosolen.
- Fig. 6: zeigt schematisch eine Schweißvorrichtung.
- Fig. 7: zeigt schematisch eine Vorrichtung zum Entfernen von Oberflächenmaterial.
- Fig. 8: zeigt schematisch eine Reinigungsvorrichtung.
- Fig. 9: zeigt schematisch eine Vorrichtung zum Laser-Plasmatrennen.

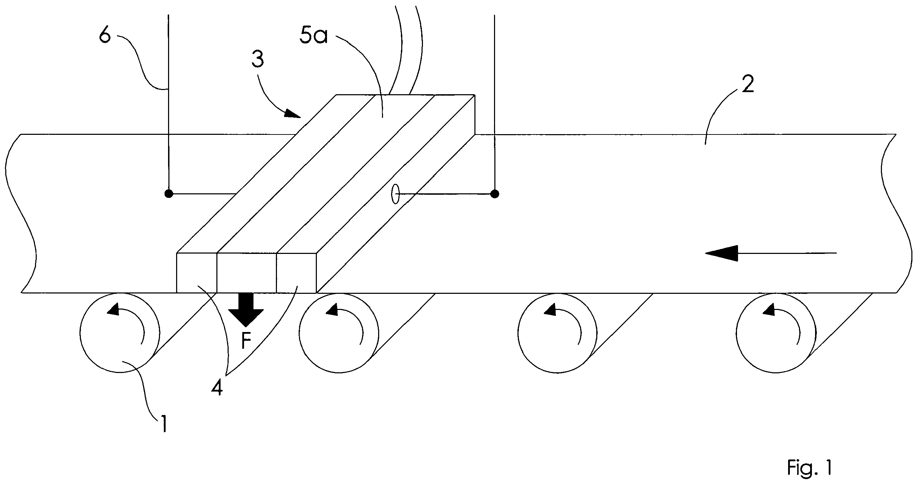

Die Fig. 1 zeigt schematisch eine Vorrichtung zum Aufsprühen von Öl. Über angetriebene Walzen 1 wird ein zu besprühendes Bandmaterial, wie z. B. ein Metallblech, geführt. In der Arbeitseinheit 3 sind ein Sonotrodenblock 4 und Sprühdüsen 5a enthalten. Der Sonotrodenblock 4 erzeugt zwischen seiner Unterseite und der Oberfläche 2 des Bandmaterials ein Ultraschall-Levitationskraftfeld. Die Arbeitseinheit 3 ist an einer beweglichen Aufhängung 6 aufgehängt und drückt auf Grund ihres Eigengewichts auf das Bandmaterial, d. h. in diesem Beispiel wird die Gravitationskraft als Drängmittel verwendet. Es könnte aber auch eine mechanische Feder oder ein anderes gleichwirkendes Mittel verwendet werden. Durch das Ultraschall-Levitationskraftfeld wird eine Gegenkraft aufgebaut, sodass die Arbeitseinheit 3 in einem vorbestimmten Abstand über der Oberfläche 2 des Bandmaterials schwebt. Dieser Abstand kann mittels der Sonotrodenleistung sehr genau eingestellt werden und bleibt dann konstant, soweit sich die Drängkraft nicht verändert. Insofern ist die Nutzung der Gravitation eine einfache, kostengünstige und zuverlässige Möglichkeit, eine definierte und sehr konstante Kraft zu erzeugen. Die Sprühdüsen 5a haben somit immer einen vorbestimmten Abstand zur Oberfläche 2 des Bandmaterials. Es ist besonders zu erwähnen, dass das Ultraschall-Levitationskraftfeld keinen Einfluss auf die Sprühwirkung der Sprühdüsen 5a hat.

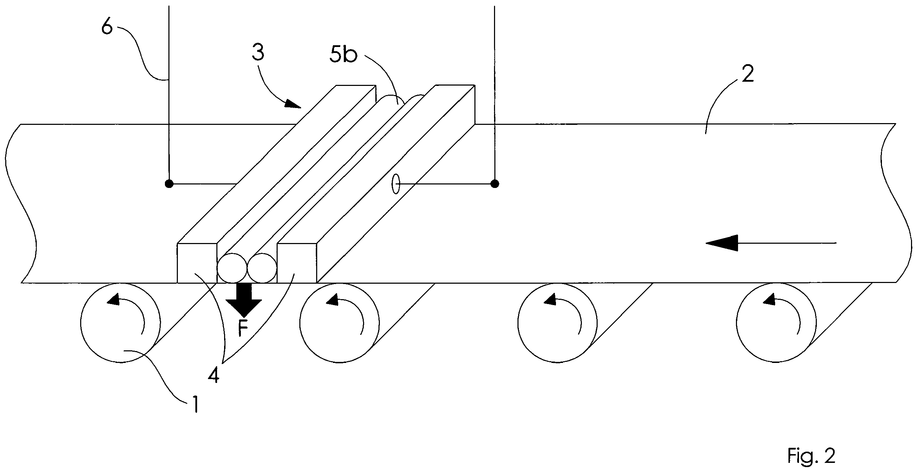

Die Fig. 2 zeigt schematisch eine Vorrichtung zum Aufbringen von Ätzmitteln. Durch die beiden dargestellten Walzen 5b wird ein dünner Ätzmittelfilm erzeugt und dieser auf die Oberfläche 2 des Bandmaterials übertragen. Der Sonotrodenblock 4 erzeugt zwischen seiner Unterseite und der Oberfläche 2 des Bandmaterials ein Ultraschall-Levitationskraftfeld. Die Arbeitseinheit 3 ist an einer beweglichen Aufhängung 6 aufgehängt und drückt auf Grund ihres Eigengewichts auf die Oberfläche 2 des Bandmaterials. Durch das Ultraschall-Levitationskraftfeld wird eine Gegenkraft aufgebaut, sodass die Arbeitseinheit 3 in einem vorbestimmten Abstand über dem Bandmaterial schwebt. Der Abstand kann über die Sonotrodenleistung eingestellt werden. So kann eine sehr gleichmäßige Ätzwirkung erzielt werden. Gleichzeitig wird der Ätzmittelfilm durch das berührungslos wirkende Ultraschall-Levitationskraftfeld nicht beeinträchtigt, d.h. weder verschmiert noch abgetragen.

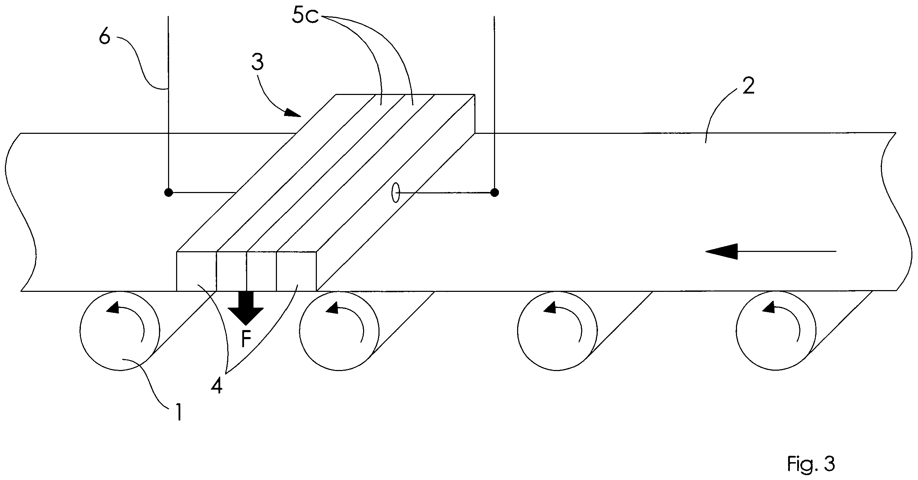

Die Fig. 3 zeigt schematisch eine Vorrichtung zum Aufbringen von Pulver. Der Sonotrodenblock 4 erzeugt zwischen seiner Unterseite und der Oberfläche 2 des Bandmaterials ein Ultraschall-Levitationskraftfeld. Die Arbeitseinheit 3 ist an einer beweglichen Aufhängung 6 aufgehängt und drückt auf Grund ihres Eigengewichts auf die Oberfläche des Bandmaterials. Durch das Ultraschall-Levitationskraftfeld wird eine Gegenkraft aufgebaut, sodass die Arbeitseinheit 3 in einem vorbestimmten Abstand über dem Bandmaterial schwebt. Der Abstand kann über die Sonotrodenleistung eingestellt werden. In den mit Bezugszeichen 5c dargestellten Austragmitteln für das Pulver, in diesem Ausführungsbeispiel einer kammerförmigen Dosiereinrichtung mit einem Schneckenverteiler und einem Rakeldosierer, wird das Pulver homogenisiert, über die Breite des Bandmaterials gleichmäßig verteilt und in gleichmäßiger Schichtdicke auf die Oberfläche 2 des Bandmaterials aufgebracht. Durch den konstanten Abstand zwischen den Walzen und der Oberfläche 2 des Bandmaterials wird dieser Prozess begünstigt. Es ist besonders zu erwähnen, dass das Ultraschall-Levitationskraftfeld keinen nennenswerten Einfluss auf die noch lose Pulverschicht hat.

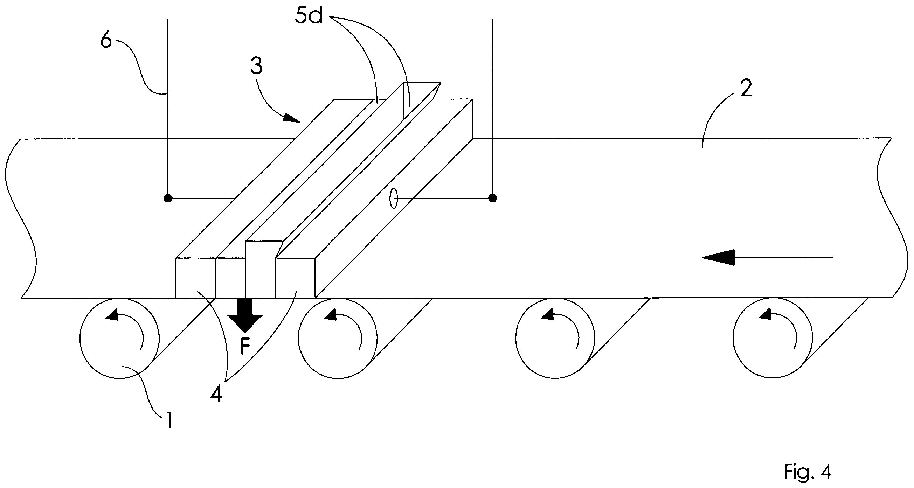

Die Fig. 4 zeigt schematisch eine Vorrichtung zum Ausbringen und zum Aushärten von Lacken. In diesem Beispiel sind mit Bezugszeichen 5d die Vorrichtungen zum Ausbringen und zum Härten des Lacks bezeichnet. Der Sonotrodenblock 4 erzeugt zwischen seiner Unterseite und der Oberfläche 2 des Bandmaterials ein Ultraschall-Levitationskraftfeld. Die Arbeitseinheit 3 ist an einer beweglichen Aufhängung 6 aufgehängt und drückt auf Grund ihres Eigengewichts auf die Oberfläche 2 des Bandmaterials. Durch das Ultraschall-Levitationskraftfeld wird eine Gegenkraft aufgebaut, sodass die Arbeitseinheit 3 in einem vorbestimmten Abstand über dem Bandmaterial schwebt. Der Abstand kann über die Sonotrodenleistung eingestellt werden. Die Vorrichtung weist einen Austragskopf auf, der eine gleichmäßige Lackschicht auf das Substrat aufbringt. Bezogen auf die Bewegungsrichtung ist dahinter ein Wärmestrahler zum Härten des Lacks angeordnet.

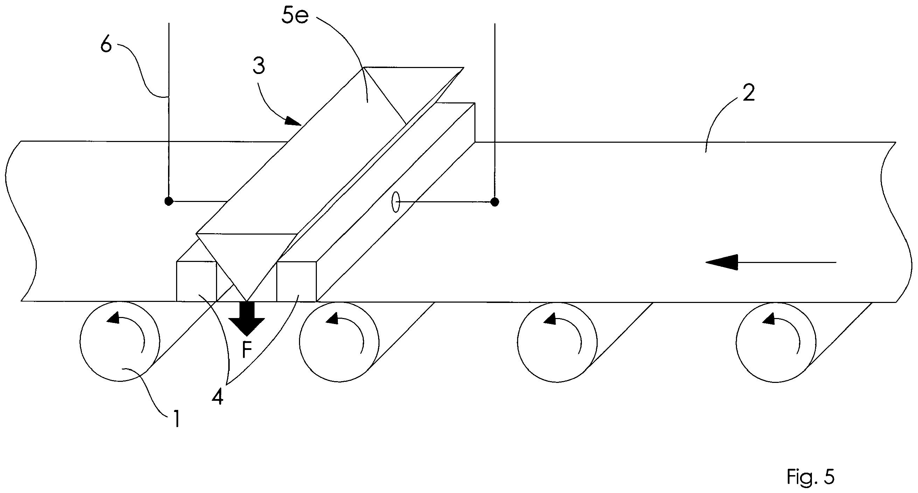

Die Fig. 5 zeigt schematisch eine Vorrichtung zum Aufbringen von Aerosolen. In diesem Ausführungsbeispiel ist mit Bezugszeichen 5e eine Vorrichtung zur Aerosolerzeugung bezeichnet. In der Arbeitseinheit 3 sind ein Sonotrodenblock 4 und die Vorrichtung 5e zur Aerosolerzeugung und zum Austragen des Aerosols angeordnet. Der Sonotrodenblock 4 erzeugt zwischen seiner Unterseite und der Oberfläche 2 des Bandmaterials ein Ultraschall-Levitationskraftfeld. Die Arbeitseinheit 3 ist an einer beweglichen Aufhängung 6 aufgehängt und drückt auf Grund ihres Eigengewichts auf die Oberfläche 2 des Bandmaterials. Durch das Ultraschall-Levitationskraftfeld wird eine Gegenkraft aufgebaut, sodass die Arbeitseinheit 3 in einem vorbestimmten Abstand über dem Bandmaterial schwebt. Der Abstand kann über die Sonotrodenleistung eingestellt werden. Das Ultraschallfeld hat keinen nennenswerten Einfluss auf die Verteilung des Aerosols.

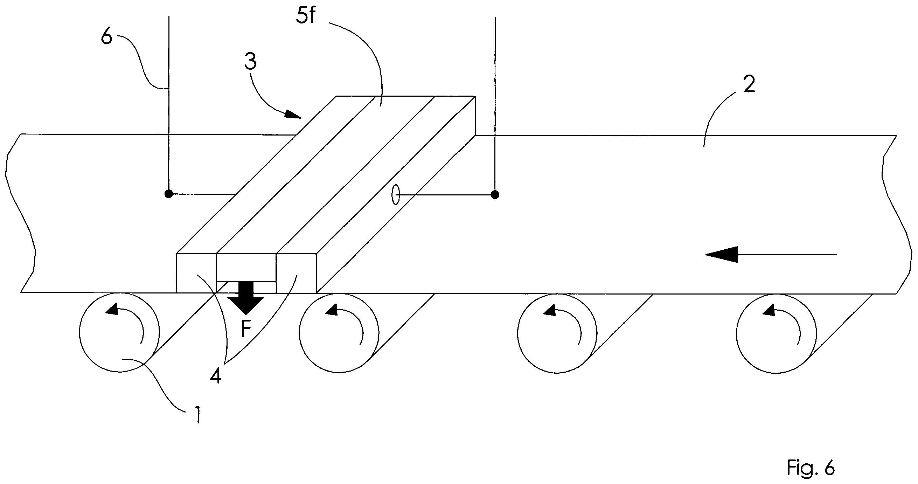

Die Fig. 6 zeigt schematisch eine Schweißvorrichtung. In diesem Beispiel ist mit Bezugszeichen 5f die Schweiß-Arbeitseinheit bezeichnet. Der Sonotrodenblock 4 erzeugt zwischen seiner Unterseite und der Oberfläche 2 des Bandmaterials ein Ultraschall-Levitationskraftfeld. Die Arbeitseinheit 3 mit dem Sonotrodenblock und der Schweiß-Arbeitseinheit 5f ist an einer beweglichen Aufhängung 6 aufgehängt und drückt auf Grund ihres Eigengewichts auf das Bandmaterial. Durch das Ultraschall-Levitationskraftfeld wird eine Gegenkraft aufgebaut, sodass die Arbeitseinheit 3 in einem vorbestimmten Abstand über dem Bandmaterial schwebt. Dieser Abstand kann über die Sonotrodenleistung eingestellt werden.

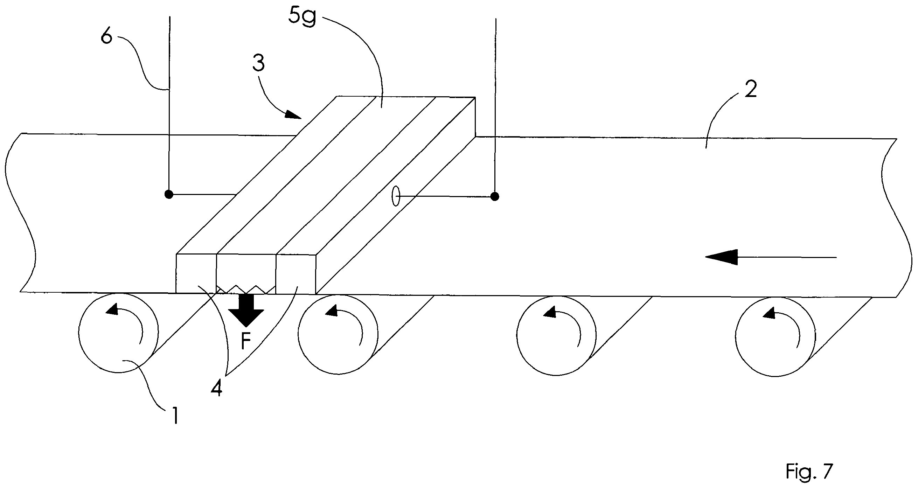

Die Fig. 7 zeigt schematisch eine Vorrichtung zum Entfernen von Oberflächenmaterial. In diesem Beispiel ist mit Bezugszeichen 5g die Arbeitseinheit zum Entfernen des Oberflächenmaterials bezeichnet. In der Arbeitseinheit 3 sind ein Sonotrodenblock 4 und die Arbeitseinheit zum Entfernen des Oberflächenmaterials mittels mechanischer Abtragmittel enthalten. Der Sonotrodenblock 4 erzeugt zwischen seiner Unterseite und der Oberfläche 2 des Bandmaterials ein Ultraschall-Levitationskraftfeld. Die Arbeitseinheit 3 ist an einer beweglichen Aufhängung 6 aufgehängt und drückt auf Grund ihres Eigengewichts auf das Bandmaterial. Durch das Ultraschall-Levitationskraftfeld wird eine Gegenkraft aufgebaut, sodass die Arbeitseinheit 3 in einem vorbestimmten Abstand über dem Bandmaterial schwebt. Der Abstand kann über die Sonotrodenleistung eingestellt werden. Durch ein Wirkmittel mit rauer Oberfläche, wie z. B. Schmirgelpapier, wird die Oberfläche abgetragen. Ebenso kann auch eine Hobeleinrichtung mit rotierenden Messern zum Einsatz kommen. Durch die sehr konstante Höhe der rotierenden Messer wird eine exakt einstellbare Materialschicht gleichmäßig abgetragen.

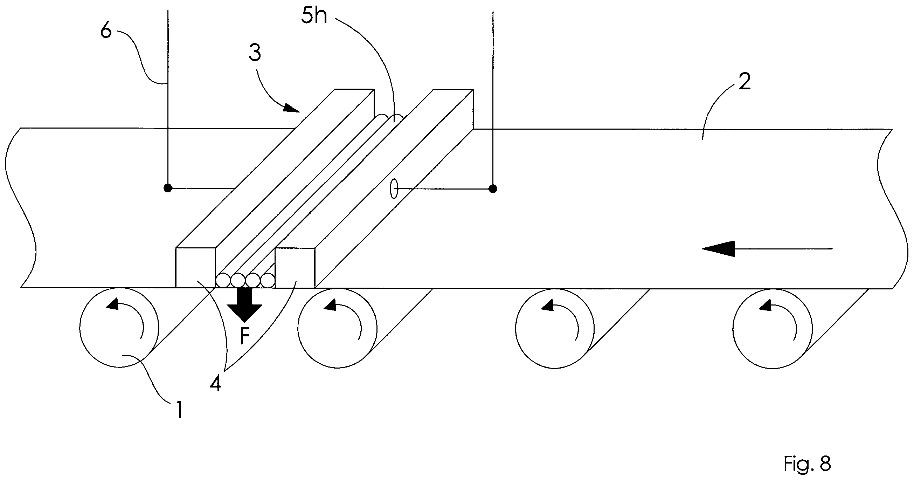

Die Fig. 8 zeigt schematisch eine Reinigungsvorrichtung. In diesem Beispiel ist mit Bezugszeichen 5h die Arbeitseinheit zum Ausbringen eines Reinigungsmittels bezeichnet. In der Arbeitseinheit 3 sind ein Sonotrodenblock 4 und die Arbeitseinheit zum Ausbringen eines Reinigungsmittels enthalten. Der Sonotrodenblock 4 erzeugt zwischen seiner Unterseite und der Oberfläche 2 des Bandmaterials ein Ultraschall-Levitationskraftfeld. Die Arbeitseinheit 3 ist an einer beweglichen Aufhängung 6 aufgehängt und drückt auf Grund ihres Eigengewichts auf das Bandmaterial. Durch das Ultraschall-Levitationskraftfeld wird eine Gegenkraft aufgebaut, sodass die Arbeitseinheit 3 in einem vorbestimmten Abstand über dem Bandmaterial schwebt. Der Abstand kann über die Sonotrodenleistung eingestellt werden. Die Anordnung der Arbeitswalzen für verschiedene Stufen der Reinigung und der Walzen zur Aufnahme des verbrauchten Reinigungsmittels kann beliebig gestaltet werden. Die Walzen können sich in unterschiedlicher Richtung drehen.

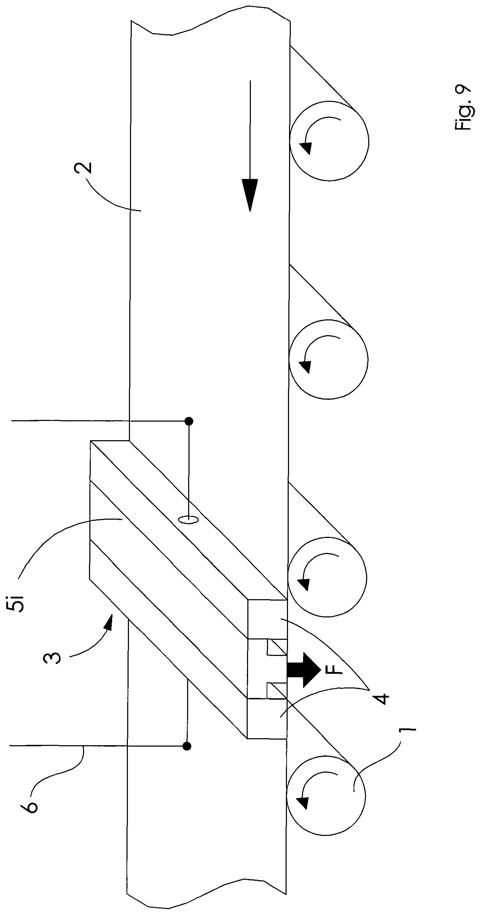

Die Fig. 9 zeigt schematisch eine Vorrichtung zum Laser-Plasmatrennen. In dem mit Bezugszeichen 5i gekennzeichneten Kasten bewegen sich die Schneidköpfe der Laser-Plasma-Arbeitseinheit. Der Sonotrodenblock 4 erzeugt zwischen seiner Unterseite und der Oberfläche 2 des Bandmaterials ein Ultraschall-Levitationskraftfeld. Die Arbeitseinheit 3 ist an einer beweglichen Aufhängung 6 aufgehängt und drückt auf Grund ihres Eigengewichts auf das Bandmaterial. Durch das Ultraschall-Levitationskraftfeld wird eine Gegenkraft aufgebaut, sodass die Arbeitseinheit 3 in einem vorbestimmten Abstand über dem Bandmaterial schwebt. Der gleichmäßige und definierte Abstand führt zu einer hohen Güte des Schnitts. Schneidrückstände beeinträchtigen die Oberflächengüte nach dem Schnitt nicht, da das System berührungslos über dem Band schwebt.

Die Figuren 1 bis 9 zeigen nur exemplarisch, dass unterschiedlichste Vorrichtungen zur Oberflächenbehandlung oder -bearbeitung nach der erfindungsgemäßen Lehre geschaffen werden können. In den genannten Beispielen wird das zu bearbeitende Material an der Arbeitseinheit vorbeigeführt. Es ist klar, dass die Arbeitseinheit nach dem gleichen Prinzip auch über die Oberfläche eines großflächigen Werkstücks geführt werden kann. Grundsätzlich ist festzustellen, dass in keinem der 9 verschiedenen Anwendungsfälle das Ultraschall-Levitationskraftfeld einen nennenswerten negativen Einfluss auf den jeweiligen Arbeitsprozess hat.

## Patentansprüche

1. Vorrichtung zur Oberflächenbehandlung oder -bearbeitung mit nachfolgenden Merkmalen:
- einem Aktuator **(5a bis 5i)** zum Einwirken auf eine Werkstückoberfläche **(2)** oder zum Bearbeiten einer Werkstückoberfläche **(2),**
- wenigstens einer Sonotrode **(4),** die eine Schallabstrahlfläche aufweist und mechanisch starr mit dem Aktuator **(5a bis 5i)** verbunden ist, um eine Arbeitseinheit **(3)** auszubilden, und
- einer mit der Arbeitseinheit **(3)** gekoppelten beweglichen Positioniervorrichtung **(6)** zum Positionieren der Arbeitseinheit **(3)** in Gegenüberlage zur Werkstückoberfläche **(2),** wobei
- die Positioniervorrichtung **(6)** ein Drängmittel aufweist oder die Gravitationskraft nutzt, um die beweglich aufgehängte Arbeitseinheit **(3)** mit einer vorbestimmten Drängkraft **(F)** in Richtung Werkstückoberfläche **(2)** zu drängen,
- die Schallabstrahlfläche der Sonotrode **(4)** Ultraschall-Schwingungen ausführt, sodass unter Anwesenheit eines gasförmigen Mediums zwischen der Werkstückoberfläche **(2)** und der Schallabstrahlfläche der Sonotrode **(4)** ein Ultraschall-Levitationskraftfeld wirkt, welches eine gegen die Drängkraft **(F)** gerichtete Gegenkraft generiert, wodurch die Arbeitseinheit **(3)** beabstandet zur Werkstückoberfläche **(2)** schwebend gehalten wird, wobei
der Aktuator **(5a bis 5i)** ausgebildet ist, um
- flüssige, pastöse, pulverförmige oder aerosolartige Medien auf die Werkstückoberfläche **(2)** aufzubringen, oder
- elektrische, magnetische oder elektromagnetische Felder oder ein Plasma an der Werkstückoberfläche **(2)** zu erzeugen, um dadurch die Werkstückoberfläche **(2)** zu verändern, oder
- ein Ultraschallfeld zum Verändern der Werkstückoberfläche **(2)** zu erzeugen, oder
- mittels mechanischer Wirkmittel zum Abtragen von Material auf die Werkstückoberfläche **(2)** einzuwirken.

2. Vorrichtung zur Oberflächenbehandlung oder -bearbeitung nach Anspruch 1, wobei an der Arbeitseinheit **(3)** Prozessüberwachungssensoren zur Prozessüberwachung oder zur Prozesssteuerung angeordnet sind.

3. Vorrichtung zur Oberflächenbehandlung oder -bearbeitung nach Anspruch 2, wobei die Prozessüberwachungssensoren optische Sensoren sind, die Bildsignale von der gerade behandelten oder bearbeiteten Werkstückoberfläche **(2)** bereitstellen.

4. Vorrichtung zur Oberflächenbehandlung oder -bearbeitung nach Anspruch 2, wobei die Prozessüberwachungssensoren kapazitive Sensoren sind, welche die durch die Oberflächenbehandlung oder -bearbeitung verursachten Kapazitätsänderungen der gerade behandelten oder bearbeiteten Werkstückoberfläche **(2)** als elektrische Messsignale bereitstellen.

5. Vorrichtung zur Oberflächenbehandlung oder -bearbeitung nach Anspruch 2, wobei die Prozessüberwachungssensoren induktive Sensoren sind, welche die durch die Oberflächenbehandlung oder -bearbeitung verursachten Induktivitätsänderungen der gerade behandelten oder bearbeiteten Werkstückoberfläche **(2)** als elektrische Messsignale bereitstellen.

6. Vorrichtung zur Oberflächenbehandlung oder -bearbeitung nach Anspruch 2, wobei bezogen auf eine Arbeitsbewegung die Prozessüberwachungssensoren vor und hinter der Arbeitseinheit **(3)** vorgesehen sind.

7. Vorrichtung zur Oberflächenbehandlung oder -bearbeitung nach Anspruch 2, wobei bezogen auf eine Arbeitsbewegung die Prozessüberwachungssensoren hinter der Arbeitseinheit **(3)** vorgesehen sind und hinter den Prozessüberwachungssensoren eine zweite Arbeitseinheit vorgesehen ist.

8. Vorrichtung zur Oberflächenbehandlung oder -bearbeitung nach Anspruch 1, wobei eine Abstandssteuerung zur Steuerung des Abstandes zwischen der Werkstückoberfläche **(2)** und der Arbeitseinheit **(3)** vorgesehen ist, wobei der Abstand durch Änderung der Schallenergie verändert wird.

## Claims

1. A device for the treatment or processing of surfaces, comprising:
- an actuator **(5a to 5i)** for acting on a workpiece surface **(2)** or for processing a workpiece surface **(2),**
- at least one sonotrode **(4)** which has a sound-radiating surface and is connected in a mechanically rigid manner to the actuator **(5a to 5i)** to form a work unit **(3),** and
- a movable positioning device **(6)** coupled to the work unit **(3),** for positioning the work unit **(3)** in a position opposite the workpiece surface **(2),** wherein
- the positioning device **(6)** has a force-applying member or uses gravitational force in order to urge the movably suspended work unit **(3)** with a predetermined urging force **(F)** in the direction of the workpiece surface **(2),**
- the sound-radiating surface of the sonotrode **(4)** generates ultrasonic vibrations such that, in the presence of a gaseous medium, an ultrasonic levitation force field acts between the workpiece surface **(2)** and the sound-radiating surface of the sonotrode **(4),** which generates a counterforce against the urging force **(F),** whereby the work unit **(3)** is held hovering at a distance from the workpiece surface **(2),**
the actuator **(5a to 5i)** being adapted to
- apply liquid, pasty, powdery or aerosol-like media on the workpiece surface **(2),** or
- generate electric, magnetic or electromagnetic fields or a plasma on the workpiece surface **(2)** in order to thereby change the workpiece surface **(2),** or
- generate an ultrasonic field for changing the workpiece surface **(2),** or
- act on the workpiece surface **(2)** by means of mechanical operating agent for removing material.

2. The device for the treatment or processing of surfaces according to claim 1, wherein process monitoring sensors for process monitoring or process control are arranged on the work unit **(3).**

3. The device for the treatment or processing of surfaces according to claim 2, wherein the process monitoring sensors are optical sensors which provide image signals of the workpiece surface **(2)** being treated or processed.

4. The device for the treatment or processing of surfaces according to claim 2, wherein the process monitoring sensors are capacitive sensors which provide as electrical measurement signals the changes in capacitance of the workpiece surface **(2)** being treated or processed, which are caused by the treatment or processing of the surface.

5. The device for the treatment or processing of surfaces according to claim 2, wherein the process monitoring sensors are inductive sensors which provide as electrical measurement signals the changes in inductance of the workpiece surface **(2)** being treated or processed, which are caused by the treatment or processing of the surface.

6. The device for the treatment or processing of surfaces according to claim 2, wherein based on a work movement, the process monitoring sensors are provided in front of and behind the work unit **(3).**

7. The device for the treatment or processing of surfaces according to claim 2, wherein based on a work movement, the process monitoring sensors are provided behind the work unit **(3)** and a second work unit is provided behind the process monitoring sensors.

8. The device for the treatment or processing of surfaces according to claim 1, wherein a distance control for controlling the distance between the workpiece surface **(2)** and the work unit **(3)** is provided, wherein the distance is changed by changing the acoustic energy.

## Revendications

1. Dispositif de traitement ou d'usinage de surfaces comprenant les caractéristiques suivantes:
- un actionneur **(5a à 5i)** destiné à agir sur une surface de pièce à usiner **(2)** ou destiné à usiner une surface de pièce à usiner **(2),**
- au moins une sonotrode **(4),** laquelle comporte une surface d'émission acoustique et est mécaniquement reliée de façon rigide à l'actionneur **(5a à 5i)** afin de former une unité de travail **(3),** et
- un dispositif de positionnement **(6)** mobile couplé à l'unité de travail **(3)** et destiné à positionner l'unité de travail **(3)** dans une position en vis-à-vis par rapport à la surface de pièce à usiner **(2),** dans lequel
- le dispositif de positionnement **(6)** comprend un moyen de refoulement ou utilise la force de gravitation afin de refouler l'unité de travail **(3),** qui est suspendue de façon mobile, avec une force de refoulement **(F)** prédéterminée en direction de la surface de pièce à usiner **(2),**
- la surface d'émission acoustique de la sonotrode **(4)** exécute des oscillations à ultrasons de sorte qu'en présence d'un milieu gazeux, un champ de force de lévitation à ultrasons exerce une action entre la surface de pièce à usiner **(2)** et la surface d'émission acoustique de la sonotrode **(4),** lequel champ de force de lévitation à ultrasons génère une force antagoniste orientée à l'encontre de la force de refoulement **(F),** permettant par cela de maintenir en balance l'unité de travail **(3)** à distance de la surface de pièce à usiner **(2),** dans lequel
l'actionneur **(5a à 5i)** est formé de façon à
- appliquer des substances liquides, pâteuses, pulvérulentes ou sous forme d'aérosol sur la surface de pièce à usiner **(2),** ou
- générer des champs électriques, magnétiques ou électromagnétiques ou un plasma au niveau de la surface de pièce à usiner **(2)** afin de modifier la surface de pièce à usiner **(2),** ou
- générer un champ à ultrasons destiné à modifier la surface de pièce à usiner **(2),** ou
- agir sur la surface de pièce à usiner **(2)** par l'intermédiaire d'un moyen d'action mécanique destiné à enlever de la matière.

2. Dispositif de traitement ou d'usinage de surfaces selon la revendication 1, dans lequel des capteurs de surveillance de processus destinés à la surveillance de processus ou au contrôle de processus sont disposés au niveau de l'unité de travail **(3).**

3. Dispositif de traitement ou d'usinage de surfaces selon la revendication 2, dans lequel les capteurs de surveillance de processus sont des capteurs optiques qui fournissent des signaux d'image de la surface de pièce à usiner **(2)** en train d'être traitée ou usinée.

4. Dispositif de traitement ou d'usinage de surfaces selon la revendication 2, dans lequel les capteurs de surveillance de processus sont des capteurs capacitifs, lesquels fournissent sous forme de signaux de mesure électriques les changements de capacité de la surface de pièce à usiner **(2)** en train d'être traitée ou usinée, lesdits changements de capacité étant causés par le traitement de surface ou par l'usinage de surface.

5. Dispositif de traitement ou d'usinage de surfaces selon la revendication 2, dans lequel les capteurs de surveillance de processus sont des capteurs inductifs, lesquels fournissent sous forme de signaux de mesure électriques les changements d'inductance de la surface de pièce à usiner **(2)** en train d'être traitée ou usinée, lesdits changements d'inductance étant causés par le traitement de surface ou par l'usinage de surface.

6. Dispositif de traitement ou d'usinage de surfaces selon la revendication 2, dans lequel, par rapport à un mouvement de travail, les capteurs de surveillance de processus sont prévus en amont et en aval de l'unité de travail **(3).**

7. Dispositif de traitement ou d'usinage de surfaces selon la revendication 2, dans lequel, par rapport à un mouvement de travail, les capteurs de surveillance de processus sont prévus en aval de l'unité de travail **(3)** et une deuxième unité de travail est prévue en aval des capteurs de surveillance de processus.

8. Dispositif de traitement ou d'usinage de surfaces selon la revendication 1, dans lequel une commande à distance est prévue pour contrôler la distance entre la surface de pièce à usiner **(2)** et l'unité de travail **(3),** la distance étant modifiée par modification de l'énergie acoustique.
